# EUROPÄISCHE PATENTSCHRIFT

(11) **EP 3 799 704 B1**
(45) Veröffentlichungstag und Bekanntmachung des Hinweises auf die Patenterteilung: **01.11.2023**
(21) Anmeldenummer: 18746635.4
(22) Anmeldetag: 17.07.2018
(51) Int. Cl.: H05K 7/20

(54) **LEISTUNGSHALBLEITERMODUL**
POWER SEMICONDUCTOR MODULE
MODULE SEMICONDUCTEUR DE PUISSANCE

(43) Veröffentlichungstag der Anmeldung: 07.04.2021
(73) Patentinhaber: Siemens Energy Global GmbH & Co. KG, 81739 München (DE)
(72) Erfinder: VIETH, Michael, 90482 Nürnberg (DE)
(86) Internationale Anmeldenummer: PCT/EP2018/069437
(87) Internationale Veröffentlichungsnummer: WO 2020/015825

(56) Entgegenhaltungen:
- WO-A1-2013/164933
- WO-A1-2017/187598
- DE-T5-112014 005 950

## Beschreibung

Die Erfindung betrifft ein Leistungshalbleitermodul mit wenigstens zwei miteinander verschalteten Leistungshalbleitereinheiten, die ansteuerbare Leistungshalbleiter-Bauelemente aufweisen, mit einem Modulgehäuse, in dem die Leistungshalbleitereinheiten angeordnet sind, wobei das Modulgehäuse eine Gehäusewand aufweist, und mit mindestens einem elektrischen Leiter zum Anschließen einer der Leistungshalbleitereinheiten, wobei sich der elektrische Leiter durch die Gehäusewand hindurch erstreckt.

Ein solches Leistungshalbleitermodul ist aus der internationalen Offenlegungsschrift WO 2009/062534 A1 bekannt. Derartige Leistungshalbleitermodule dienen insbesondere zum Aufbau von Stromrichtern, beispielsweise von modularen Multilevel-Stromrichtern.

Durch den bei Leistungshalbleitermodulen oftmals großen fließenden elektrischen Strom werden (aufgrund des ohmschen Widerstands) der bzw. die elektrischen Leiter erwärmt. Diese Erwärmung der elektrischen Leiter hat unerwünschte Verluste zur Folge, sowie oftmals eine ebenfalls unerwünschte Erwärmung der Umgebung des Leistungshalbleitermoduls. Wenn die elektrischen Leiter stark erwärmt werden, kann zusätzlich die Langzeitstabilität von Kontakten/Anschlüssen der elektrischen Leiter verschlechtert werden.

Zur Lösung dieses Problems ist es denkbar, die Querschnittsfläche des elektrischen Leiters sehr groß auszugestalten. Dadurch wird zum einen der ohmsche Widerstand des elektrischen Leiters verringert, so dass eine geringere strombedingte Erwärmung des elektrischen Leiters auftritt. Außerdem verteilt sich der Strom auf einen größeren Querschnitt, was ebenfalls dazu führt, die Temperatur des elektrischen Leiters zu senken. Diese Lösung führt allerdings zu erhöhten Materialkosten und einem erhöhten Gewicht der Leistungshalbleitermodule. Außerdem werden (bedingt durch die größeren Biegeradien der dann notwendigen elektrischen Leiter) auch die Größe und damit der Platzbedarf der Leistungshalbleitermodule vergrößert.

Aus der internationalen Patentanmeldung WO 2013/164933 A1 ist ein Stromrichter für ein elektrisch antreibbares Fahrzeug bekannt. Der Stromrichter ist in ein Gehäuse eingebaut. Durch eine Wand des Gehäuses hindurch erstrecken sich elektrische Anschlüsse. Die Wand weist einen Kühlmittelkanal mit einem Kühlmitteleinlass und einem Kühlmittelauslass auf.

Die Patentanmeldung WO 2017/187598 A1 offenbart einen Stromrichter mit einem Gehäuse, das aus einem Hauptteil und einem Deckel besteht. Der Deckel weist eine ausgesparte Nut auf, die einem Kühlmittelkanal bildet. Ein elektrischer Leiter erstreckt sich durch den Deckel.

Der Erfindung liegt die Aufgabe zugrunde, ein Leistungshalbleitermodul und ein Verfahren anzugeben, bei denen eine unerwünscht starke Erwärmung des elektrischen Leiters vermieden wird.

Diese Aufgabe wird erfindungsgemäß gelöst durch ein Leistungshalbleitermodul und durch ein Verfahren gemäß den unabhängigen Patentansprüchen. Vorteilhafte Ausgestaltungen des Leistungshalbleitermoduls und des Verfahrens sind in den abhängigen Patentansprüchen angegeben.

Offenbart wird ein Leistungshalbleitermodul mit wenigstens zwei miteinander verschalteten Leistungshalbleitereinheiten, die ansteuerbare Leistungshalbleiter-Bauelemente aufweisen, mit einem Modulgehäuse, in dem die Leistungshalbleitereinheiten angeordnet sind, wobei das Modulgehäuse eine Gehäusewand (Seitenwand) aufweist, und mit einem elektrischen Leiter zum Anschließen einer der Leistungshalbleitereinheiten, wobei sich der elektrische Leiter durch die Gehäusewand hindurch erstreckt (d.h. die Gehäusewand durchdringt) und wobei die Gehäusewand einen Kühlmittelkanal (für ein flüssiges Kühlmittel) zum Kühlen des elektrischen Leiters aufweist. Hierbei ist besonders vorteilhaft, dass die Gehäusewand den Kühlmittelkanal aufweist. Mittels dieses Kühlmittelkanals kann die Gehäusewand und damit auch der elektrische Leiter gekühlt werden. Dabei ist der Kühlmittelkanal vorzugsweise zur Aufnahme eines flüssigen Kühlmittels (beispielsweise deionisiertes Wasser) ausgestaltet. Der Kühlmittelkanal ist insbesondere flüssigkeitsdicht.

Das Leistungshalbleitermodul ist so ausgestaltet, dass der Kühlmittelkanal eine Ausnehmung der Gehäusewand bildet. Die Ausgestaltung des Kühlmittelkanals als eine Ausnehmung der Gehäusewand ist vorteilhaft, weil dadurch kein zusätzlicher Platz für den Kühlmittelkanal notwendig ist. Außerdem liegt der Kühlmittelkanal geschützt in der Gehäusewand und ist beispielsweise vor einer Beschädigung mit darauffolgendem Auslaufen des Kühlmittels gut geschützt.

Das Leistungshalbleitermodul ist so ausgestaltet, dass der Kühlmittelkanal benachbart zu dem elektrischen Leiter angeordnet ist. Dadurch kann das den Kühlmittelkanal durchströmende Kühlmittel die in dem elektrischen Leiter entstehende Wärme besonders gut aufnehmen.

In einer alternativen, nicht anspruchsgemässen Ausführung kann das Leistungshalbleitermodul auch so ausgestaltet sein, dass der Kühlmittelkanal entlang seiner Erstreckung von der Gehäusewand umschlossen ist. Der Kühlmittelkanal ist insbesondere von dem Material der Gehäusewand umschlossen. Es handelt sich um einen längsseitig geschlossenen Kühlmittelkanal. Dies hat den Vorteil, dass der Kühlmittelkanal auf einfache Art und Weise flüssigkeitsdicht ausgestaltet werden kann. Außerdem ist ein von der Gehäusewand umschlossener Kühlmittelkanal mechanisch besonders stabil.

Das Leistungshalbleitermodul ist so ausgestaltet, dass der Kühlmittelkanal zumindest abschnittsweise zu dem elektrischen Leiter hin offen ist, so dass die den Kühlmittelkanal bildende Ausnehmung der Gehäusewand in unmittelbarem Kontakt mit dem elektrischen Leiter steht. Dadurch kann den Kühlmittelkanal durchströmendes Kühlmittel in unmittelbaren Kontakt mit dem elektrischen Leiter gelangen. Dadurch kann eine besonders effektive Kühlung des elektrischen Leiters erreicht werden.

In einer alternativen, nicht anspruchsgemässen Ausführung kann das Leistungshalbleitermodul auch so ausgestaltet sein, dass zwischen dem Kühlmittelkanal und dem elektrischen Leiter ein Wärmeleitelement angeordnet ist, dessen Wärmeleitfähigkeit größer ist als die Wärmeleitfähigkeit der Gehäusewand. Bei dieser Ausgestaltungsvariante ist der Kühlmittelkanal ebenfalls entlang seiner Erstreckung geschlossen. Durch das Wärmeleitelement wird die Wärmeübertragung zwischen dem elektrischen Leiter und dem durch den Kühlmittelkanal fließenden Kühlmittel verbessert.

In dieser alternative Ausführung kann das Leistungshalbleitermodul auch so ausgestaltet sein, dass das Wärmeleitelement aus einem Metall besteht. Ein Metall (beispielsweise Edelstahl oder Aluminium) weist im Allgemeinen eine große Wärmeleitfähigkeit auf. Das Wärmeleitelement verhindert den direkten Kontakt zwischen dem Kühlmittel und dem elektrischen Leiter. Der elektrische Leiter besteht nämlich oftmals aus Kupfer. Durch das Wärmeleitelement wird verhindert, dass Kupferionen in das Kühlmittel übergehen. Dadurch werden unerwünschte chemische Reaktionen verhindert. Alternativ kann man den elektrischen Leiter im Kühlmittel-Kontaktbereich auch oberflächenbeschichten, um den unerwünschten Übergang von Kupferionen in das Kühlmittel zu verhindern.

Das Leistungshalbleitermodul kann auch so ausgestaltet sein, dass das Wärmeleitelement ein (metallischer) Wärmeleitstreifen ist, der in einer Nut der Gehäusewand angeordnet (insbesondere in die Nut eingelegt) ist. Ein derartiger Wärmeleitstreifen lässt sich vorteilhafterweise gut in der Gehäusewand anordnen.

Das Leistungshalbleitermodul kann auch so ausgestaltet sein, dass die Gehäusewand ein elektrisch isolierendes Material, insbesondere einen Kunststoff, aufweist. Insbesondere kann die Gehäusewand aus dem elektrisch isolierenden Material bestehen. Durch die Verwendung des elektrisch isolierenden Materials können vorteilhafterweise die Leistungshalbleitereinheiten elektrische isoliert werden.

Das Leistungshalbleitermodul kann auch so ausgestaltet sein, dass der elektrische Leiter eine Stromschiene ist. Insbesondere für Stromschienen, die für große elektrische Stromstärken ausgelegt sind, ist die beschriebene Art der Kühlung mittels des Kühlmittelkanals besonders wirkungsvoll.

Das Leistungshalbleitermodul kann auch so ausgestaltet sein, dass der elektrische Leiter eine langgestreckte Querschnittsfläche aufweist und der Kühlmittelkanal entlang der Längserstreckung der Querschnittsfläche verläuft. Dadurch kann in dem der elektrischen Leiter erzeugte Wärme besonders wirkungsvoll von dem den Kühlmittelkanal durchströmenden Kühlmittel aufgenommen werden. Dabei kann die Länge der Querschnittsfläche mindestens 3-mal so lang wie die Breite der Querschnittsfläche sein, insbesondere mindestens 5-mal so lang.

Das Leistungshalbleitermodul kann auch so ausgestaltet sein, dass der elektrische Leiter eine (langgestreckte, insbesondere ungleichseitige) rechteckige Querschnittsfläche aufweist und der Kühlmittelkanal entlang der längeren Seite der rechteckigen Querschnittsfläche verläuft. Dadurch kann in dem elektrischen Leiter erzeugte Wärme besonders wirkungsvoll von dem den Kühlmittelkanal durchströmenden Kühlmittel aufgenommen werden. Insbesondere kann der Kühlmittelkanal im Wesentlichen parallel zu der längeren Seite der rechteckigen Querschnittsfläche verlaufen. Die längere Seite der rechteckigen Querschnittsfläche kann dabei 3-mal so lang ist wie die kürzere Seite der rechteckigen Querschnittsfläche, insbesondere 5-mal so lang.

Das Leistungshalbleitermodul kann so ausgestaltet sein, dass die Gehäusewand zwei Kühlmittelkanäle aufweist, die beidseitig des elektrischen Leiters angeordnet sind. Dadurch kann der elektrische Leiter vorteilhafterweise beidseitig gekühlt werden. Dadurch können besonders große Wärmemengen von dem elektrischen Leiter abgeführt werden und dadurch die Temperatur des elektrischen Leiters gesenkt werden.

Das Leistungshalbleitermodul kann auch so ausgestaltet sein, dass das Leistungshalbleitermodul mehrere elektrische Leiter (zum Anschließen der Leistungshalbleitereinheiten) aufweist, die sich durch die Gehäusewand hindurch erstrecken und denen jeweils mindestens ein Kühlmittelkanal zugeordnet ist. Dadurch kann vorteilhafterweise jeder der elektrischen Leiter gekühlt werden.

Offenbart wird weiterhin ein Stromrichter mit einer Vielzahl der vorstehend beschriebenen Leistungshalbleitermodule. Ein derartiger Stromrichter kann insbesondere ein Mehrstufenstromrichter sein, wobei jedes Leistungshalbleitermodul einer Stufe (Spannungsstufe) dieses Stromrichters zugeordnet ist. Derartige Stromrichter werden auch als modulare Multilevel-Stromrichter bezeichnet.

Offenbart wird weiterhin ein Verfahren zum Kühlen eines Leistungshalbleitermoduls
- mit wenigstens zwei miteinander verschalteten Leistungshalbleitereinheiten, die ansteuerbare Leistungshalbleiter-Bauelemente aufweisen,
- mit einem Modulgehäuse, in dem die Leistungshalbleitereinheiten angeordnet sind, wobei das Modulgehäuse eine Gehäusewand aufweist, und
- mit einem elektrischen Leiter zum Anschließen einer der Leistungshalbleitereinheiten, wobei sich der elektrische Leiter durch die Gehäusewand hindurch erstreckt, wobei bei dem Verfahren
- mittels eines in der Gehäusewand verlaufenden Kühlmittelkanals (für ein flüssiges Kühlmittel) der elektrische Leiter gekühlt wird, wobei der Kühlmittelkanal zumindest abschnittsweise zu dem elektrischen Leiter hin offen ist, so dass die den Kühlmittelkanal bildende Ausnehmung der Gehäusewand in unmittelbarem Kontakt mit dem elektrischen Leiter steht.

Das Verfahren weist gleichartige Ausprägungen und Vorteile auf, wie sie oben im Zusammenhang mit dem Leistungshalbleitermodul angegeben sind.

Im Folgenden wird die Erfindung anhand von Ausführungsbeispielen näher erläutert. Gleiche Bezugszeichen verweisen dabei auf gleiche oder gleichwirkende Elemente.

Dazu ist in
- Figur 1: ein Ausführungsbeispiel eines Leistungshalbleitermoduls in einer dreidimensionalen Ansicht, in

- Figur 2: ein alternatives, nicht der beanspruchten Erfindung entsprechendes Leistungshalbleitermodul in einer Schnittdarstellung, in den
- Figuren 3 bis 5: weitere Ausführungsbeispiele von erfindungsgemässen bzw von nicht der beanspruchten Erfindung entsprechenden Halbleitermodulen in einer Schnittdarstellung, in
- Figur 6: ein weiteres Ausführungsbeispiel eines Leistungshalbleitermoduls in einer dreidimensionalen Ansicht, und in den
- Figuren 7 bis 9: Teile von weiteren Ausführungsbeispielen von Leistungshalbleitermodulen dargestellt.

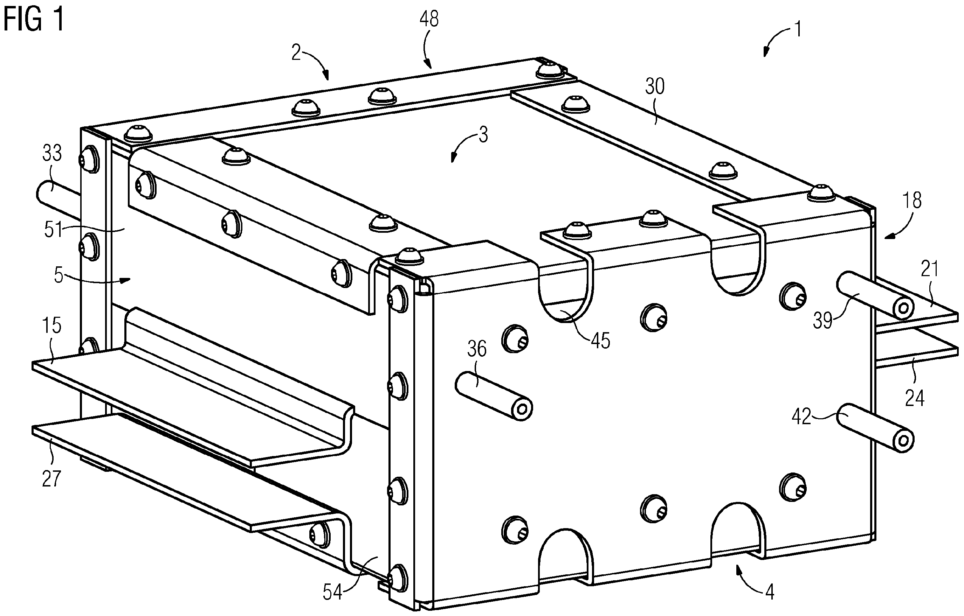

In Figur 1 ist ein Ausführungsbeispiel eines Leistungshalbleitermoduls 1 dargestellt. Dieses Leistungshalbleitermodul 1 weist ein Modulgehäuse 2 auf. Das Modulgehäuse 2 weist eine obere Modulgehäusewand 3 und eine untere Modulgehäusewand 4 auf. Die untere Modulgehäusewand 4 ist insbesondere eine Grundplatte 4 des Leistungshalbleitermoduls 1; die obere Modulgehäusewand 3 ist insbesondere eine Deckplatte 3 des Leistungshalbleitermoduls 1.

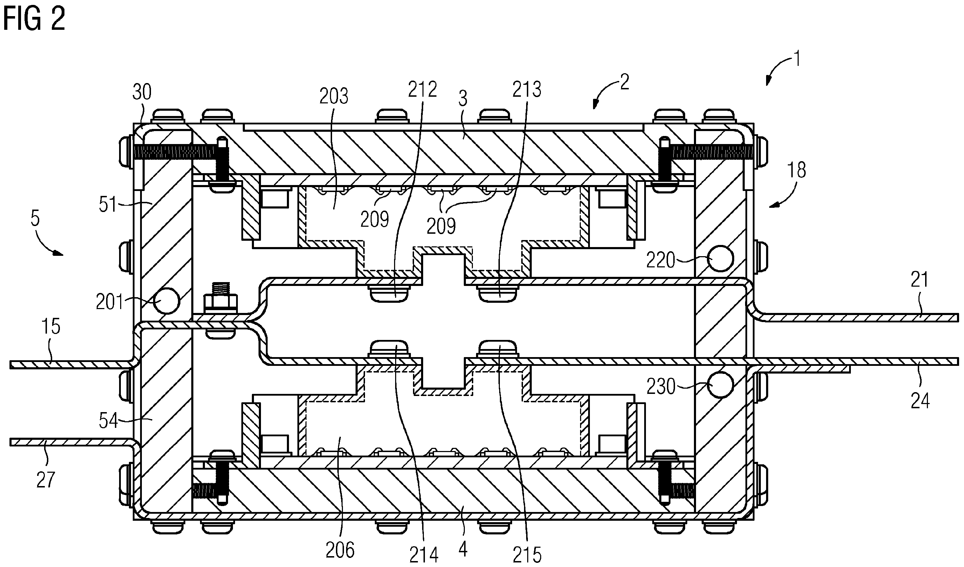

Weiterhin weist das Modulgehäuse eine erste Gehäusewand 5 auf, welche die untere Modulgehäusewand 4 mit der oberen Modulgehäusewand 3 verbindet. Die erste Gehäusewand 5 stellt eine Seitenwand 5 des Modulgehäuses 2 dar. Ein erster elektrischer Leiter 15 erstreckt sich durch die erste Gehäusewand 5 hindurch. Der erste elektrische Leiter 15 durchgreift bzw. durchdringt die erste Gehäusewand 5. Dieser erste elektrische Leiter 15 dient zum Anschließen von im dem Modulgehäuse enthaltenen Leistungshalbleitereinheiten, vgl. Figur 2. Weiterhin weist das Leistungshalbleitermodul 1 eine zweite Gehäusewand 18 auf. Durch diese zweite Gehäusewand 18 hindurch erstrecken sich ein zweiter elektrischer Leiter 21 und ein dritter elektrischer Leiter 24. Im Ausführungsbeispiel sind die erste Gehäusewand 5 und die zweite Gehäusewand 18 parallel angeordnet und bilden gegenüberliegende Gehäusewände des Modulgehäuses 2.

Weiterhin weist das Leistungshalbleitermodul 1 einen vierten elektrischen Leiter 27 auf. Dieser vierte elektrische Leiter 27 erstreckt sich jedoch nicht durch eine Gehäusewand, sondern verläuft am Ende der ersten Gehäusewand 5 und damit an einer Begrenzungsfläche des Leistungshalbleitermoduls 1.

Die vier elektrischen Leiter 15, 21, 24 und 27 sind im Ausführungsbeispiel jeweils als eine Stromschiene ausgestaltet. Diese Stromschienen haben jeweils eine langgestreckte Querschnittsfläche. Im Ausführungsbeispiel haben die Stromschienen jeweils eine (ungleichseitige) rechteckige Querschnittsfläche. Ungleichseitig bedeutet hier, dass die rechteckige Querschnittsfläche eine längere Seite und eine kürzere Seite aufweist.

Das Leistungshalbleitermodul 1 weist Profilschienen 30 auf, welche die Gehäusewände des Leistungshalbleitermoduls mechanisch miteinander verbinden. Weiterhin weist das Leistungshalbleitermodul 1 einen ersten Kanalanschluss 33, einen zweiten Kanalanschluss 36, einen dritten Kanalanschluss 39 und einen vierten Kanalanschluss 42 auf. Diese vier Kanalanschlüsse 33, 36, 39 und 42 sind mit (in Figur 1 nicht sichtbaren) Kühlmittelkanälen verbunden, welche in der ersten Seitenwand 5 und in der zweiten Gehäusewand 18 angeordnet sind. Die Kanalanschlüsse 36, 39 und 42 sind an einer dritten Gehäusewand 45 angeordnet; der Kanalanschluss 33 ist an einer vierten Gehäusewand 48 angeordnet. Die dritten Gehäusewand 45 und die vierte Gehäusewand 48 sind parallel zueinander angeordnet und verlaufen senkrecht zu der ersten Gehäusewand 5 und der zweiten Gehäusewand 18.

Weiterhin ist in Figur 1 erkennbar, dass die erste Gehäusewand 5 ein erstes Gehäusewandteil 51 und ein zweites Gehäusewandteil 54 aufweist (erstes Seitenwandteil 51, zweites Seitenwandteil 54). Die erste Gehäusewand 5 ist also eine zweiteilige/zweigeteilte Gehäusewand, was die Montage des ersten elektrischen Leiters 15 vereinfacht.

In Figur 2 ist eine Schnittdarstellung eines alternativen, nicht der beanspruchten Erfindung entsprechenden Leistungshalbleitermoduls 1 dargestellt. In dieser Schnittdarstellung ist erkennbar, dass das Leistungshalbleitermodul 1 eine erste Leistungshalbleitereinheit 203 und eine zweite Leistungshalbleitereinheit 206 aufweist. Die Leistungshalbleitereinheiten 203 und 206 weisen jeweils ansteuerbare Leistungshalbleiter-Bauelemente 209 auf, welche im Ausführungsbeispiel als mittels Bonddrähten verdrahtete Leistungshalbleiter-Chips ausgestaltet sind.

Die obere Modulgehäusewand 3 ist als eine Kühlplatte 3 ausgebildet, es handelt sich insbesondere um eine Metallplatte 3. Mittels dieser oberen Modulgehäusewand 3 wird die erste Leistungshalbleitereinheit 203 gekühlt. Ebenso bildet die untere Modulgehäusewand 4 eine Kühlplatte 4 für die zweite Leistungshalbleitereinheit 206.

Die erste Gehäusewand 5 und die zweite Gehäusewand 18 (sowie die dritte Gehäusewand 45 und die vierte Gehäusewand 48) bestehen aus einem elektrisch isolierenden Material, insbesondere aus einem Kunststoff. Dadurch werden die obere Modulgehäusewand 3 und die untere Modulgehäusewand 4 (und damit die erste Leistungshalbleitereinheit 203 und die zweite Leistungshalbleitereinheit 206) elektrisch voneinander isoliert. In einem anderen Ausführungsbeispiel können die Gehäusewände 5, 18, 45 und/oder 48 (Seitenwände 5, 18, 45 und/oder 48) aber auch aus einem anderen Material bestehen, beispielsweise aus einem elektrisch leitenden Material (zum Beispiel aus einem Metall). In diesem Fall kann die elektrische Isolierung zwischen den beiden Leistungshalbleitereinheiten 203, 206 anders realisiert sein, beispielsweise über eine nichtleitende Zwischenschicht zwischen der oberen Modulgehäusewand 3 und der Leistungshalbleitereinheit 203.

Die Leistungshalbleitereinheiten 203 und 206 weisen jeweils Anschlüsse 212, 213, 214 bzw. 215 auf, mittels der sie mit den elektrischen Leitern elektrisch verbunden sind. So ist beispielsweise die zweite Leistungshalbleitereinheit 206 mittels des Anschlusses 214 mit dem ersten elektrischen Leiter 15 elektrisch verbunden. Weiterhin ist die zweite Leistungshalbleitereinheit 206 mittels des elektrischen Anschlusses 215 mit dem dritten elektrischen Leiter 24 elektrisch verbunden. Ebenso ist die erste Leistungshalbleitereinheit 203 mittels des Anschlusses 213 mit dem zweiten elektrischen Leiter 21 elektrisch verbunden.

Die erste Leistungshalbleitereinheit 203 und die zweite Leistungshalbleitereinheit 206 sind miteinander elektrisch verschaltet und bilden beispielsweise eine sogenannte Halbbrückenschaltung. Die ansteuerbaren Leistungshalbleiterbauelemente 209 sind im Ausführungsbeispiel als IGBTs ausgestaltet. In einem anderen Ausführungsbeispiel können jedoch auch andere ansteuerbare Leistungshalbleiterbauelement verwendet werden, beispielsweise GTOs, IGCTs oder ähnliches. IGBTs, GTOs und IGCTs sind abschaltbare Leistungshalbleiterbauelemente, das heißt, diese können nicht nur elektrisch eingeschaltet, sondern auch elektrisch abgeschaltet werden. Es können aber auch nicht abschaltbare Leistungshalbleiterbauelemente wie Thyristoren o.ä. eingesetzt werden. Die Leistungshalbleitereinheiten können weiterhin zusätzlich andere Leistungshalbleiter aufweisen, welche nicht ansteuerbar sind, wie Dioden, Freilaufdioden oder Ähnliches.

Das Leistungshalbleitermodul 1 weist einen ersten Kühlmittelkanal 201 zum Kühlen des ersten elektrischen Leiters 15 auf. Der erste Kühlmittelkanal 201 ist in der ersten Gehäusewand 5 angeordnet. Der erste Kühlmittelkanal 201 ist eine Ausnehmung der Gehäusewand 5. Im Ausführungsbeispiel hat der erste Kühlmittelkanal 201 eine runde Querschnittsfläche; der erste Kühlmittelkanal 1 ist ein Kühlmittelkanal in Form einer Bohrung in der ersten Gehäusewand 5. In anderen Ausführungsbeispielen kann der Kühlmittelkanal aber auch eine andere Querschnittsfläche aufweisen, beispielsweise eine rechteckige, quadratische oder ovale Querschnittsfläche.

Der erste Kühlmittelkanal 201 ist ausgestaltet, ein flüssiges Kühlmittel aufzunehmen, um den ersten elektrischen Leiter 15 zu kühlen. Das flüssige Kühlmittel strömt zu diesem Zweck durch den Kühlmittelkanal 201. Der erste Kühlmittelkanal 201 ist benachbart zu dem ersten elektrischen Leiter 15 angeordnet. Dadurch kann der erste Kühlmittelkanal (beziehungsweise das diesen durchströmende Kühlmittel) die in dem ersten elektrischen Leiter 15 entstehende Wärme aufnehmen. Die erste Gehäusewand 5 mit dem ersten Kühlmittelkanal 201 stellt eine Kühldose für den ersten elektrischen Leiter 15 dar (Stromschienenkühldose).

Der erste Kühlmittelkanal 201 ist entlang seiner Erstreckung (senkrecht zur Papierebene der Figur 2) von der ersten Gehäusewand 5 umschlossen. Mit anderen Worten ist der erste Kühlmittelkanal 201 entlang seiner Erstreckung von dem Material der ersten Gehäusewand 5 umschlossen. Es handelt sich also um einen längsseitig geschlossenen beziehungsweise umschlossenen Kühlmittelkanal 201.

Die zweite Gehäusewand 18 wird von dem zweiten elektrischen Leiter 21 und von dem dritten elektrischen Leiter 24 durchdrungen, das heißt, der zweite elektrische Leiter 21 und der dritte elektrische Leiter 24 erstrecken sich durch die zweite Gehäusewand 18 hindurch. Benachbart zu dem zweiten elektrischen Leiter 21 ist ein zweiter Kühlmittelkanal 220 angeordnet. Ein dritter Kühlmittelkanal 230 ist benachbart zu dem dritten elektrischen Leiter 24 angeordnet. Damit dient der zweite Kühlmittelkanal 220 der Kühlung des zweiten elektrischen Leiters 21; der dritte Kühlmittelkanal 230 ist zur Kühlung des dritten elektrischen Leiters 24 ausgebildet.

Beim Ausführungsbeispiel der Figur 2 werden die elektrischen Leiter jeweils einseitig mittels jeweils eines Kühlmittelkanals gekühlt. Das heißt, jedem elektrischen Leiter ist ein Kühlmittelkanal zugeordnet, der auf einer Seite des jeweiligen elektrischen Leiters angeordnet ist. Die Enden der Kühlmittelkanäle sind mit den entsprechenden Kanalanschlüssen verbunden, vgl. Figur 1. So ist beispielsweise ein erstes Ende des ersten Kühlmittelkanals 201 mit dem ersten Kanalanschluss 33 verbunden, und ein zweites Ende des ersten Kühlmittelkanals 201 ist mit dem zweiten Kanalanschluss 36 verbunden. In gleicher Art und Weise weist der zweite Kühlmittelkanal 220 zwei Kanalanschlüsse auf, von denen in Figur 1 nur der dritte Kanalanschluss 39 sichtbar ist. Ebenso weist der dritte Kühlmittelkanal 230 zwei Kanalanschlüsse auf, von denen in der Figur 1 nur der vierte Kanalanschluss 42 sichtbar ist.

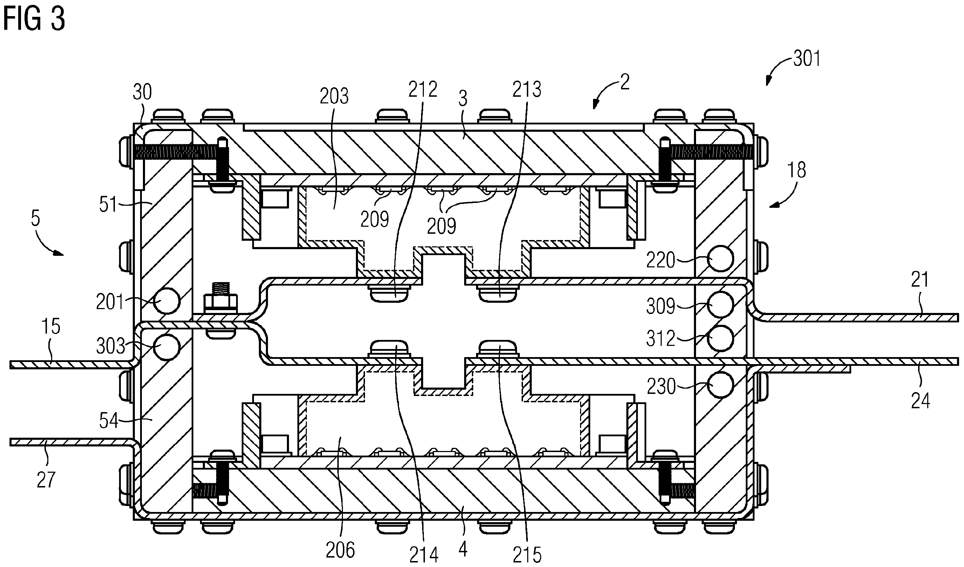

In Figur 3 ist eine Schnittdarstellung eines weiteren alternativen, nicht der beanspruchten Erfindung entsprechenden Ausführungsbeispiels eines Leistungshalbleitermoduls 301 dargestellt. Im Unterschied zu dem Leistungshalbleitermodul 1 der Figur 2 weist hierbei die erste Gehäusewand 5 zusätzlich zu dem ersten Kühlmittelkanal 201 einen vierten Kühlmittelkanal 303 auf. Dabei ist der erste Kühlmittelkanal 201 in dem ersten Gehäusewandteil 51 angeordnet; der vierte Kühlmittelkanal 303 ist in dem zweiten Gehäusewandteil 54 angeordnet. Der erste Kühlmittelkanal 201 ist auf einer Seite des ersten elektrischen Leiters 15 angeordnet; der vierte Kühlmittelkanal 303 ist auf der gegenüberliegenden Seite des ersten elektrischen Leiters 15 angeordnet. Die erste Gehäusewand 5 weist also zwei Kühlmittelkanäle 201 und 303 auf, die beidseitig des ersten elektrischen Leiters 15 angeordnet sind. Dadurch wird eine beidseitige Kühlung des ersten elektrischen Leiters 15 ermöglicht.

In gleicher Art und Weise ist in der zweiten Gehäusewand 18 zusätzlich zu dem zweiten Kühlmittelkanal 220 und dem dritten Kühlmittelkanal 230 ein fünfter Kühlmittelkanal 309 und ein sechster Kühlmittelkanal 312 angeordnet. Mittels des zweiten Kühlmittelkanals 220 und des fünften Kühlmittelkanals 309 wird der zweite elektrische Leiter 21 gekühlt. Mittels des dritten Kühlmittelkanals 230 und des sechsten Kühlmittelkanals 312 wird der dritte elektrische Leiter 24 beidseitig gekühlt.

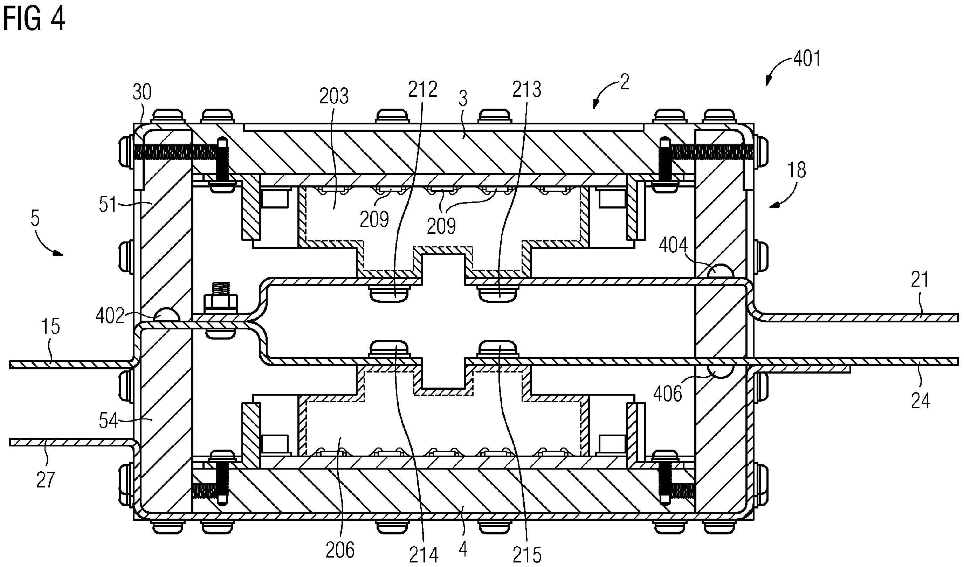

In Figur 4 ist ein weiteres, der beanspruchten Erfindung entsprechendes Ausführungsbeispiel eines Leistungshalbleitermoduls 401 dargestellt. Dieses Leistungshalbleitermodul 401 unterscheidet sich von dem Leistungshalbleitermodul 1 der Figur 2 dadurch, dass die Kühlmittelkanäle (zumindest abschnittsweise im Bereich des elektrischen Leiters) zu dem jeweiligen elektrischen Leiter hin offen sind. So ist beispielsweise der erste Kühlmittelkanal 402 zu dem ersten elektrischen Leiter 15 hin offen ausgebildet. Die den ersten Kühlmittelkanal 402 bildende Ausnehmung der ersten Gehäusewand 5 steht also in unmittelbarem Kontakt zu dem ersten elektrischen Leiter 15.

Dadurch kann den ersten Kühlmittelkanal 402 durchströmendes Kühlmittel in unmittelbarem Kontakt mit dem elektrischen Leiter 15 stehen, das heißt, dieses Kühlmittel berührt unmittelbar den ersten elektrischen Leiter 15. Dadurch kann der erste elektrische Leiter 15 mittels des ersten Kühlmittelkanals besonders effektiv gekühlt werden. Der zweite Kühlmittelkanal 404 und der dritte Kühlmittelkanal 406 sind gleichartig ausgebildet.

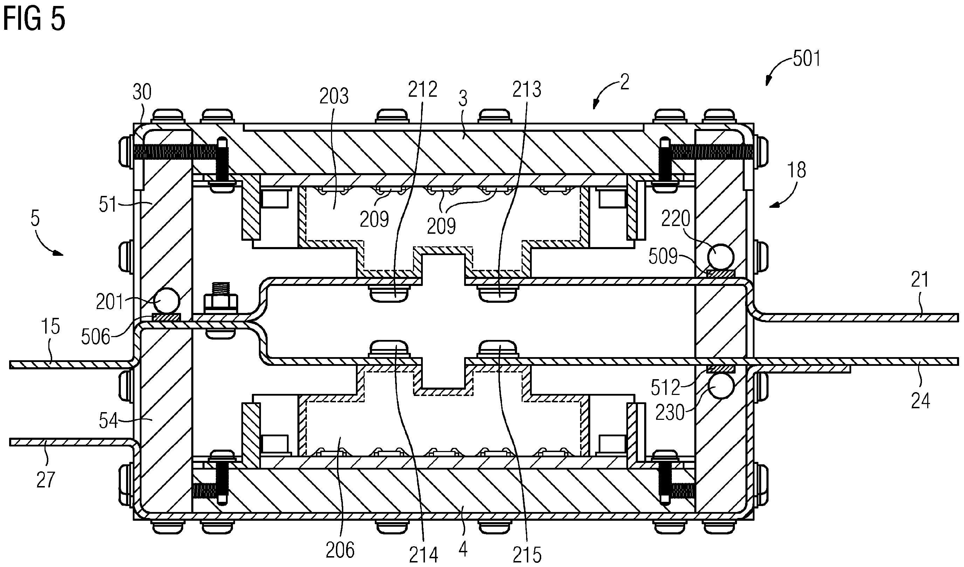

In Figur 5 ist ein weiteres alternatives, nicht der beanspruchten Erfindung entsprechendes Ausführungsbeispiel eines Leistungshalbleitermoduls 501 dargestellt. Dieses Leistungshalbleitermodul 501 unterscheidet sich von dem Leistungshalbleitermodul 1 der Figur 2 dadurch, dass zwischen den Kühlmittelkanälen und dem jeweiligen elektrischen Leiter ein Wärmeleitelement angeordnet ist, dessen Wärmeleitfähigkeit größer ist als die Wärmeleitfähigkeit der Gehäusewand. So ist beispielsweise zwischen dem ersten Kühlmittelkanal 201 und dem ersten elektrischen Leiter 15 ein erstes Wärmeleitelement 506 angeordnet. Dieses erste Wärmeleitelement 506 hat eine größere Wärmeleitfähigkeit als die Wärmeleitfähigkeit der ersten Gehäusewand 5. Dadurch wird die Wärmeleitung zwischen dem ersten elektrischen Leiter 15 und dem ersten Kühlmittelkanal 201 verbessert. Das Wärmeleitelement 506 kann insbesondere aus einem Metall bestehen, wie beispielsweise Kupfer oder Edelstahl. Im Ausführungsbeispiel ist das erste Wärmeleitelement 506 als ein metallischer Wärmeleitstreifen 506 ausgestaltet, der in einer Nut der Gehäusewand 5 angeordnet ist. Das erste Wärmeleitelement 506 kann dabei den ersten Kühlmittelkanal 201 zum ersten elektrischen Leiter 15 hin begrenzen. Das erste Wärmeleitelement 506 steht insbesondere in direktem Kontakt mit dem ersten elektrischen Leiter 15.

Zwischen dem zweiten Kühlmittelkanal 220 und dem zweiten elektrischen Leiter 21 ist in gleicher Art und Weise ein zweites Wärmeleitelement 509 angeordnet. Gleichartig ist zwischen dem dritten Kühlmittelkanal 230 und dem dritten elektrischen Leiter 24 ein drittes Wärmeleitelement 512 angeordnet.

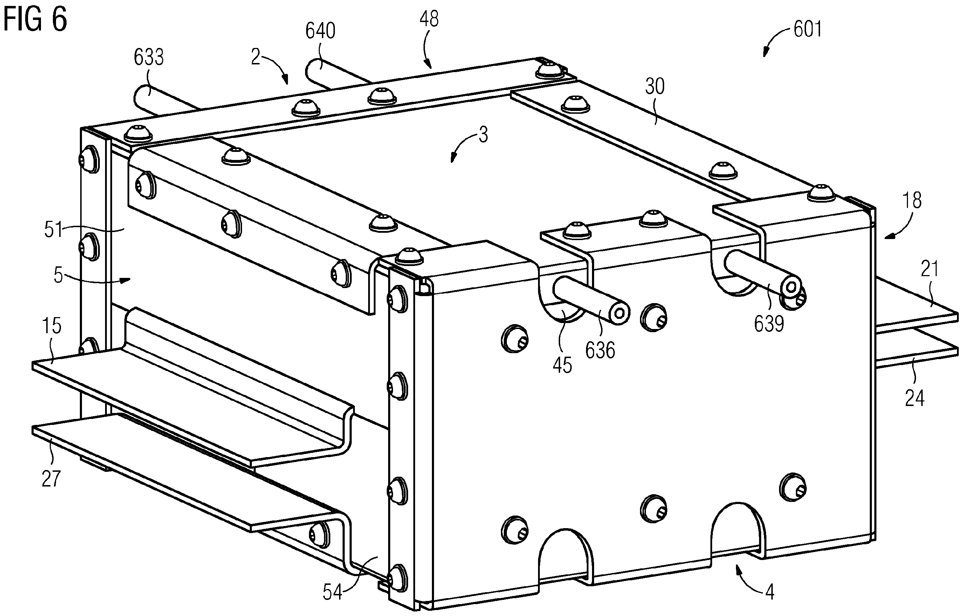

In Figur 6 ist ein weiteres Ausführungsbeispiel eines Leistungshalbleitermoduls 601 dargestellt. Dieses Leistungshalbleitermodul 601 unterscheidet sich von dem Leistungshalbleitermodul 1 der Figur 1 dadurch, dass der erste Kanalanschluss 633, der zweite Kanalanschluss 636, der dritte Kanalanschluss 639 sowie ein weiterer (in Figur 1 nicht sichtbarer) Kanalanschluss 640 im Bereich der oberen Modulgehäusewand 3 des Moduls angeordnet sind. In diesem Fall verlaufen die jeweiligen Kühlmittelkanäle 201 beziehungsweise 220 von der jeweiligen Gehäusewand zu der oberen Modulgehäusewand, verlaufen abschnittsweise innerhalb der oberen Modulgehäusewand 3 und verlassen die obere Modulgehäusewand 3 als dargestellte Kanalanschlüsse 633, 636, 639 bzw. 640. Dies hat den Vorteil, dass mittels der Kühlmittelkanäle zusätzlich zu den elektrischen Leitern auch gleichzeitig die obere Modulgehäusewand 3 (die als eine Kühlplatte 3 ausgestaltet ist) gekühlt werden kann.

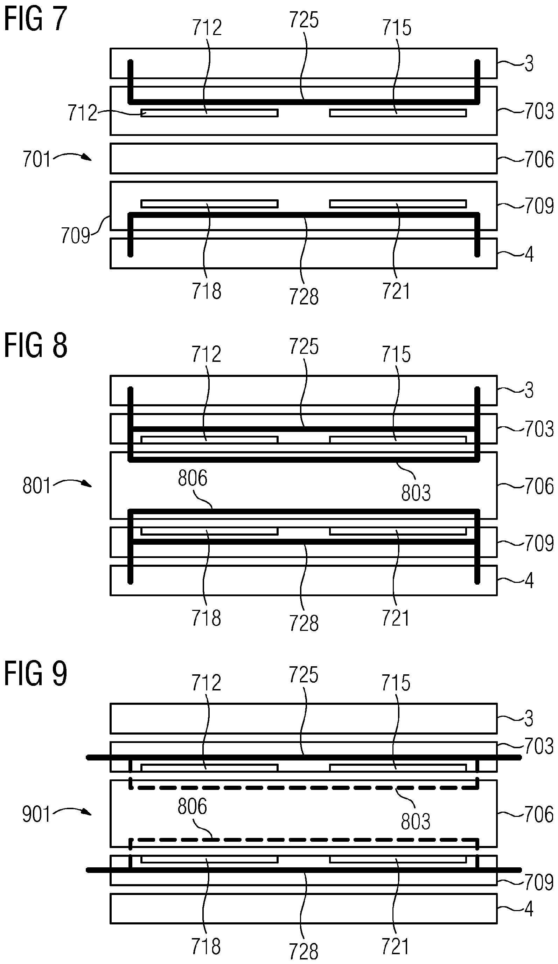

In Figur 7 ist ein weiteres Ausführungsbeispiel eines Leistungshalbleitermoduls 701 in einer Seitenansicht dargestellt. Die Ansicht zeigt die Sicht auf die Gehäusewand mit den sich durch die Gehäusewand hindurch erstreckenden elektrischen Leitern. Im Ausführungsbeispiel ist das Leistungshalbleitermodul sandwichartig aufgebaut (Sandwichaufbau). Aus Gründen der Übersichtlichkeit ist zwischen den einzelnen Teilen ein Abstand gelassen, ähnlich einer Explosionsdarstellung. Im montierten Zustand liegen die einzelnen Teile des Leistungshalbleitermoduls jedoch unbeabstandet aneinander an.

Im oberen Teil der Figur 7 ist die obere Modulgehäusewand 3 schematisch dargestellt. Daran schließt sich ein erstes Gehäusewandteil 703, ein zweites Gehäusewandteil 706, ein drittes Gehäusewandteil 709 und die untere Modulgehäusewand 4 an. Das zweite Gehäusewandteil 703 wird von einem ersten elektrischen Leiter 712 (erste Stromschiene 712) und von einem zweiten elektrischen Leiter 715 (zweite Stromschiene 715) durchdrungen. Ein dritter elektrischer Leiter 718 (dritte Stromschiene 718) und ein vierter elektrischer Leiter 721 (vierte Stromschiene 721) erstrecken sich durch das dritte Gehäusewandteil 709.

Das erste Gehäusewandteil 703 weist einen ersten Kühlmittelkanal 725 auf, der benachbart zu dem ersten elektrischen Leiter 712 und dem zweiten elektrischen Leiter 715 verläuft. Dieser erste Kühlmittelkanal 725 erstreckt sich in die obere Modulgehäusewand 3, an der auch die zwei zugehörigen Kanalanschlüsse angeordnet sind (in der Figur 7 nicht dargestellt). In ähnlicher Weise weist das dritte Gehäusewandteil 709 einen zweiten Kühlmittelkanal 728 auf, der benachbart zu dem dritten elektrischen Leiter 718 und dem vierten elektrischen Leiter 721 angeordnet ist.

In Figur 8 ist ein weiteres Ausführungsbeispiel eines Halbleitermoduls 801 dargestellt. Dieses Ausführungsbeispiel unterscheidet sich von dem Ausführungsbeispiel der Figur 7 dadurch, dass ein dritter Kühlmittelkanal 803 vorhanden ist, mit dem der erste elektrische Leiter 712 und der zweite elektrische Leiter 715 von der zweiten Seite her gekühlt werden. Der dritte Kühlmittelkanal 803 erstreckt sich in dem zweiten Gehäusewandteil 706. In dem zweiten Gehäusewandteil 706 erstreckt sich weiterhin ein vierter Kühlmittelkanal 806, welcher dem dritten elektrischen Leiter 718 und dem vierten elektrischen Leiter 721 zugeordnet ist. Dadurch werden auch der dritte elektrische Leiter 718 und der vierte elektrische Leiter 721 beidseitig gekühlt.

Der erste Kühlmittelkanal 725 und der dritte Kühlmittelkanal 803 verlaufen zu der oberen Modulgehäusewand 3; an dieser oberen Modulgehäusewand 3 sind die zugehörigen Kanalanschlüsse angeordnet. Der zweite Kühlmittelkanal 728 und der vierte Kühlmittelkanal 806 verlaufen zu der unteren Modulgehäusewand 4; an dieser unteren Modulgehäusewand 4 sind die zugehörigen Kanalanschlüsse angeordnet. Der dritte Kühlmittelkanal 803 und/oder der vierte Kühlmittelkanal 806 sind optional, d.h. sie können auch weggelassen werden.

In Figur 9 ist ein weiteres Ausführungsbeispiel eines Leistungshalbleitermoduls 901 dargestellt. Dieses Ausführungsbeispiel unterscheidet sich von dem Ausführungsbeispiel der Figur 8 im Wesentlichen dadurch, dass die Kühlmittelkanäle außerhalb der oberen Modulgehäusewand 3 und der unteren Modulgehäusewand 4 verlaufen und dass die Kanalanschlüsse an dem ersten Gehäusewandteil 703 und dem dritten Gehäusewandteil 709 angeordnet sind. Die strichliert dargestellten Kühlkanäle sind optional und können auch weggelassen werden.

Die in den Figuren 7 bis 9 dargestellten Gehäusewandteile (Seitenwandteile) können Bestandteile von Gehäuserahmenteilen sein, welche übereinandergestapelt die vier Gehäusewände (Seitenwände) des Modulgehäuses bilden. Diese Gehäuserahmenteile sind rahmenförmige Teile, welche den Raum für die Leistungshalbleitereinheiten umgeben.

Es wurde ein Leistungshalbleitermodul und ein Verfahren beschrieben, bei dem sich durch die Gehäusewand erstreckende elektrische Leiter mittels jeweils mindestens eines Kühlmittelkanals gekühlt werden. Es wird also ein aktive Kühlung, insbesondere eine aktive Flüssigkeitskühlung (beispielsweise eine aktive Wasserkühlung), der elektrischen Leiter realisiert. Dadurch können elektrische Leiter mit vergleichsweise geringen Querschnittsflächen eingesetzt werden, ohne dass sich die Temperatur der elektrischen Leiter unerwünscht stark erhöht. Dadurch können vorteilhafterweise Materialkosten gespart und das Gewicht des Leistungshalbleitermoduls reduziert werden. Weiterhin können die Leistungshalbleitermodule kleiner aufgebaut sein (durch kleinere Biegeradien der elektrischen Leiter) beziehungsweise bei gleichbleibender Größe der Leistungshalbleitermodule können größere Ströme über die elektrischen Leiter fließen.

Es wird also Bauraum für die Leistungshalbleitermodule gespart, insbesondere Bauraum bei einem Stromrichter, der mittels der Leistungshalbleitermodule aufgebaut ist.

Durch die geringere Temperatur der elektrischen Leiter erwärmt sich auch die Umgebung der Leistungshalbleitermodule geringer, was ebenfalls vorteilhaft ist und Kosten spart (geringere Anforderungen an Kühlung, Raumklimatisierung oder ähnliches). Durch die beschriebene aktive Kühlung werden strombedingt in den elektrischen Leitern auftretende Wärmemengen in Kühlflüssigkeit (zum Beispiel Kühlwasser) abgeleitet, welche durch die Kühlmittelkanäle strömt. Dadurch wird eine effektive Kühlung realisiert.

## Patentansprüche

1. Leistungshalbleitermodul (1)
- mit wenigstens zwei miteinander verschalteten Leistungshalbleitereinheiten (203, 206), die ansteuerbare Leistungshalbleiter-Bauelemente (209) aufweisen,
- mit einem Modulgehäuse (2), in dem die Leistungshalbleitereinheiten (203, 206) angeordnet sind, wobei das Modulgehäuse (2) eine Gehäusewand (5) aufweist, und
- mit einem elektrischen Leiter (15) zum Anschließen einer der Leistungshalbleitereinheiten (206), wobei sich der elektrische Leiter (15) durch die Gehäusewand (5) hindurch erstreckt, wobei
- die Gehäusewand (5) einen Kühlmittelkanal (201) zum Kühlen des elektrischen Leiters (15) aufweist,
**dadurch gekennzeichnet, dass**
- der Kühlmittelkanal (402) zumindest abschnittsweise zu dem elektrischen Leiter (15) hin offen ist, so dass die den Kühlmittelkanal bildende Ausnehmung der Gehäusewand in unmittelbarem Kontakt mit dem elektrischen Leiter steht.

2. Leistungshalbleitermodul nach Anspruch 1, **dadurch gekennzeichnet, dass**
- die Gehäusewand (5) ein elektrisch isolierendes Material, insbesondere einen Kunststoff, aufweist.

3. Leistungshalbleitermodul nach einem der vorhergehenden Ansprüche,
**dadurch gekennzeichnet, dass**
- der elektrische Leiter (15, 21, 24, 712, 715, 718, 721) eine Stromschiene ist.

4. Leistungshalbleitermodul nach einem der vorhergehenden Ansprüche,
**dadurch gekennzeichnet, dass**
- der elektrische Leiter (15, 21, 24, 712, 715, 718, 721) eine langgestreckte Querschnittsfläche aufweist und der Kühlmittelkanal (201, 725) entlang der Längserstreckung der Querschnittsfläche verläuft.

5. Leistungshalbleitermodul nach einem der vorhergehenden Ansprüche,
**dadurch gekennzeichnet, dass**
- der elektrische Leiter (15, 21, 24, 712, 715, 718, 721) eine rechteckige Querschnittsfläche aufweist und der Kühlmittelkanal (201, 725) entlang der längeren Seite der rechteckigen Querschnittsfläche verläuft.

6. Leistungshalbleitermodul nach einem der vorhergehenden Ansprüche,
**dadurch gekennzeichnet, dass**
- die Gehäusewand (5) zwei Kühlmittelkanäle (201, 303) aufweist, die beidseitig des elektrischen Leiters (15) angeordnet sind.

7. Leistungshalbleitermodul nach einem der vorhergehenden Ansprüche,
**dadurch gekennzeichnet, dass**
- das Leistungshalbleitermodul (1) mehrere elektrische Leiter (21, 24) aufweist, die sich durch die Gehäusewand (18) hindurch erstrecken und denen jeweils mindestens ein Kühlmittelkanal (220, 230) zugeordnet ist.

8. Stromrichter mit einer Vielzahl von Leistungshalbleitermodulen (1) nach einem der Ansprüche 1 bis 7.

9. Verfahren zum Kühlen eines Leistungshalbleitermoduls (1)
- mit wenigstens zwei miteinander verschalteten Leistungshalbleitereinheiten (203, 206), die ansteuerbare Leistungshalbleiter-Bauelemente (209) aufweisen,
- mit einem Modulgehäuse (2), in dem die Leistungshalbleitereinheiten (203, 206) angeordnet sind, wobei das Modulgehäuse (2) eine Gehäusewand (5) aufweist, und
- mit einem elektrischen Leiter (15) zum Anschließen einer der Leistungshalbleitereinheiten (206), wobei sich der elektrische Leiter (15) durch die Gehäusewand (5) hindurch erstreckt, wobei bei dem Verfahren
- mittels eines in der Gehäusewand (5) verlaufenden Kühlmittelkanals (201) der elektrische Leiter (15) gekühlt wird, wobei der Kühlmittelkanal (402) zumindest abschnittsweise zu dem elektrischen Leiter (15) hin offen ist, so dass die den Kühlmittelkanal bildende Ausnehmung der Gehäusewand in unmittelbarem Kontakt mit dem elektrischen Leiter steht.

## Claims

1. Power semiconductor module (1)
- comprising at least two interconnected power semiconductor units (203, 206) having controllable power semiconductor components (209),
- comprising a module housing (2), in which the power semiconductor units (203, 206) are arranged, the module housing (2) having a housing wall (5), and
- comprising an electrical conductor (15) for connecting one of the power semiconductor units (206), the electrical conductor (15) extending through the housing wall (5),
- the housing wall (5) having a coolant channel (201) for cooling the electrical conductor (15),
**characterized in that**
- the coolant channel (402) is open towards the electrical conductor (15) at least sectionally, such that the cutout in the housing wall that forms the coolant channel is in direct contact with the electrical conductor.

2. Power semiconductor module according to Claim 1, **characterized in that**
- the housing wall (5) comprises an electrically insulating material, in particular a plastic.

3. Power semiconductor module according to either of the preceding claims,
**characterized in that**
- the electrical conductor (15, 21, 24, 712, 715, 718, 721) is a busbar.

4. Power semiconductor module according to any of the preceding claims,
**characterized in that**
- the electrical conductor (15, 21, 24, 712, 715, 718, 721) has an elongated cross-sectional area, and the coolant channel (201, 725) runs along the longitudinal extension of the cross-sectional area.

5. Power semiconductor module according to any of the preceding claims,
**characterized in that**
- the electrical conductor (15, 21, 24, 712, 715, 718, 721) has a rectangular cross-sectional area, and the coolant channel (201, 725) runs along the longer side of the rectangular cross-sectional area.

6. Power semiconductor module according to any of the preceding claims,
**characterized in that**
- the housing wall (5) has two coolant channels (201, 303) arranged on both sides of the electrical conductor (15).

7. Power semiconductor module according to any of the preceding claims,
**characterized in that**
- the power semiconductor module (1) has a plurality of electrical conductors (21, 24) which extend through the housing wall (18) and to each of which at least one coolant channel (220, 230) is assigned.

8. Power converter comprising a multiplicity of power semiconductor modules (1) according to any of Claims 1 to 7.

9. Method for cooling a power semiconductor module (1)
- comprising at least two interconnected power semiconductor units (203, 206) having controllable power semiconductor components (209),
- comprising a module housing (2), in which the power semiconductor units (203, 206) are arranged, the module housing (2) having a housing wall (5), and
- comprising an electrical conductor (15) for connecting one of the power semiconductor units (206), the electrical conductor (15) extending through the housing wall (5), wherein in the method
- the electrical conductor (15) is cooled by means of a coolant channel (201) running in the housing wall (5), wherein the coolant channel (402) is open towards the electrical conductor (15) at least sectionally, such that the cutout in the housing wall that forms the coolant channel is in direct contact with the electrical conductor.

## Revendications

1. Module (1) à semiconducteur de puissance
- comprenant au moins deux unités (203, 206) à semiconducteur de puissance, qui sont connectées entre elles et qui ont des composants (209) à semiconducteur de puissance pouvant être commandés,
- comprenant un boîtier (2) de module, dans lequel les unités (203, 206) à semiconducteur de puissance sont disposés, dans lequel le boîtier (2) de module a une paroi (5) de boîtier, et
- comprenant un conducteur (15) électrique de raccordement de l'une des unités (206) à semiconducteur de puissance, dans lequel le conducteur (15) électrique passe à travers la paroi (5) du boîtier, dans lequel
- la paroi (5) du boîtier a un conduit (201) pour du réfrigérant pour le refroidissement du conducteur (15) électrique, **caractérisé en ce que**
- le conduit (402) pour du réfrigérant est, au moins par endroits, ouvert vers le conducteur (15) électrique, de sorte que l'évidement, formant le conduit pour le réfrigérant, de la paroi du boîtier est en contact direct avec le conducteur électrique.

2. Module à semiconducteur de puissance suivant la revendication 1,
**caractérisé en ce que**
- la paroi (5) du boîtier comporte un matériau isolant électriquement, en particulier une matière plastique.

3. Module à semiconducteur de puissance suivant l'une des revendications précédentes,
**caractérisé en ce que**
- le conducteur (15, 21, 24, 712, 715, 718, 721) électrique est une barre de courant.

4. Module à semiconducteur de puissance suivant l'une des revendications précédentes,
**caractérisé en ce que**
- le conducteur (15, 21, 24, 712, 715, 718, 721) électrique a une surface de section transversale s'étendant en longueur et le conduit (201, 725) pour du réfrigérant s'étend le long de l'étendue en longueur de la surface de section transversale.

5. Module à semiconducteur de puissance suivant l'une des revendications précédentes,
**caractérisé en ce que**
- le conducteur (15, 21, 24, 712, 715, 718, 721) électrique a une surface de section transversale rectangulaire et le conduit (201, 725) pour du réfrigérant s'étend le long du grand côté de la surface de section transversale rectangulaire.

6. Module à semiconducteur de puissance suivant l'une des revendications précédentes,
**caractérisé en ce que**
- la paroi (5) du boîtier a deux conduits (201, 303) pour du réfrigérant, qui sont disposés de part et d'autre du conducteur (15) électrique.

7. Module à semiconducteur de puissance suivant l'une des revendications précédentes,
**caractérisé en ce que**
- le module (1) à semiconducteur de puissance a plusieurs conducteurs (21, 24) électriques, qui traversent la paroi (18) du boîtier et auxquels est associé respectivement au moins un conduit (220, 230) pour du réfrigérant.

8. Convertisseur ayant une pluralité de modules (1) à semiconducteur de puissance suivant l'une des revendications 1 à 7.

9. Procédé de refroidissement d'un module (1) à semiconducteur de puissance
- comprenant au moins deux unités (203, 206) à semiconducteur de puissance, qui sont connectées entre elles, et qui ont des composants (209) à semiconducteur de puissance pouvant être commandés,
- comprenant un boîtier (2) de module, dans lequel les unités (203, 206) à semiconducteur de puissance sont disposés, dans lequel le boîtier (2) de module a une paroi (5) de boîtier, et
- comprenant un conducteur (15) électrique de raccordement de l'une des unités (206) à semiconducteur de puissance, dans lequel le conducteur (15) électrique passe à travers la paroi (5) du boîtier, dans lequel, dans le procédé
- au moyen d'un conduit (201) pour du réfrigérant s'étendant dans la paroi (5) du boîtier, on refroidit le conducteur (15) électrique, dans lequel le conduit (402) pour du réfrigérant est, au moins par endroits, ouvert vers le conducteur (15) électrique, de sorte que l'évidement, formant le conduit pour le réfrigérant, de la paroi du boîtier est en contact direct avec le conducteur électrique.
